# EUROPEAN PATENT APPLICATION

(11) **EP 4 425 563 A2**
(43) Date of publication of application: **04.09.2024**
(21) Application number: 24158040.6
(22) Date of filing: 16.02.2024
(51) Int. Cl.: H01L 29/06, H01L 29/08, H01L 29/34, H01L 29/78, H01L 21/04, H01L 21/336

(54) **ELECTRONIC DEVICE WITH AUTOALIGNED CSL AND EDGE TERMINATION STRUCTURE, AND MANUFACTURING METHOD THEREOF**

(30) Priority: 03.03.2023 IT 202300003849
(71) Applicant: STMicroelectronics International N.V., 1228 Plan-les-Ouates, Geneva (CH)
(72) Inventor: GUARNERA, Alfio, 95039 TRECASTAGNI (CT) (IT); SAGGIO, Mario Giuseppe, 95020 ACI BONACCORSI (CT) (IT); CAMALLERI, Cateno Marco, 95125 CATANIA (IT); ZANETTI, Edoardo, 95028 VALVERDE (CT) (IT)
(74) Representative: Studio Torta S.p.A.

(57) **Abstract**

Method of manufacturing an electronic device, comprising the steps of: arranging a semiconductor body (50) of N-type, having a lattice structure with spatial symmetry, comprising an active area (34) an edge region (36) surrounding the active area; forming, in the edge region, an intentionally damaged region (80) wherein the lattice structure has no spatial symmetry; forming an edge termination region (58; 58, 68) of P-type at the damaged region, by random implant; forming a current spreading layer, CSL, (70) in the edge region (36) at and lateral to the damaged region, by channeled implant. The CSL has, at the damaged region, a minimum thickness and, laterally to the damaged region, a maximum thickness. The minimum thickness is lower than the thickness of the edge termination region.

## Description

The invention relates to an electronic device and a manufacturing method thereof, in particular an electronic device with a current spreading layer (CSL) with variable thickness.

Ion implant is nowadays a well-established technique for introducing dopants into Silicon Carbide, SiC, since dopant spreading is not an applicable technique due to the low diffusivity of SiC compared to other semiconductor materials (such as, for example, Silicon), and epitaxial growth might not be a useful alternative, particularly for locally confined volumes.

As known, the crystalline structure of SiC affects, during implant, the depth distribution obtained. In fact, the so-called channeling may considerably increase the penetration depth of the ions into the crystalline material with respect to an amorphous target. This phenomenon may occur if the direction of the impinging ion beam is nearly parallel to the main crystallographic axes or planes. In these directions, the reduction in energy loss per ion pathlength is smaller and thus the ions move deeper into the target.

In order to theoretically describe the probability of channeling, the concept of "critical channeling angle" has been introduced. In this case, the critical angle is considered as the maximum angle between the axial rows of atoms and the incoming beam at which the ions will still be guided along that axis. To investigate and predict the channeling phenomena during ion implant, nowadays there exists different software for Monte Carlo simulation in crystalline targets, for example using the binary collision approximation (MC-BCA).

Channeling is often an undesired effect, and generally, the SiC wafer is tilted in a random, non-channeling direction to minimize the channeling effects during implant. Doping profiles more or less Gaussian with respect to depth are thus obtained, where the depth is determined by the energy, the ions used and the target atomic structure. On the other hand, if the implant is performed along a crystallographic axis, a completely different profile will be obtained wherein the ions follow the direction of the crystal in depth into the target. In SiC, it has been demonstrated that the deepest channeled ions may penetrate the expected action range many times for the corresponding random implant.

In order to form locally confined implanted regions, it is known to use hard masks, for example of silicon oxide (SiO₂), configured to locally shield the SiC wafer during the implant step. However, the Applicant has verified that using hard masks of the aforementioned type may cause planarity problems of the layer having the mask applied thereto, after removing the same mask, due to the lattice stress effect generated on the SiC substrate by the presence of this hard mask.

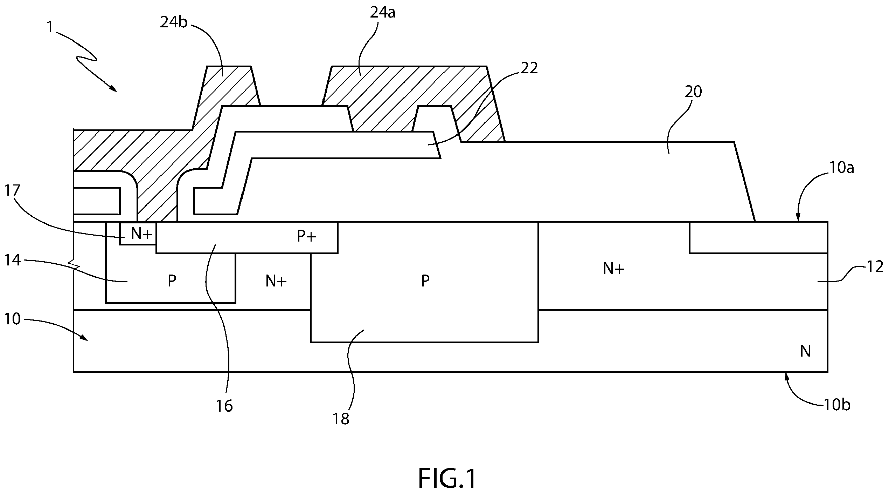

With reference to Figure 1, a portion of an electronic device 1 is illustrated, for example a power MOSFET, limitedly to an edge region thereof which surrounds an active area. The electronic device 1 includes: a semiconductor body 10 of SiC having a first electrical conductivity of N-type, delimited by a front side 10a and a rear side 10b opposite to each other; a current spreading layer (CSL) 12 of N-type and greater doping than the doping of the semiconductor body 10, which extends into the semiconductor body 10 starting from the front side for a depth, for example, of 1pm; a body region 14, having a second electrical conductivity (P-type) opposite to the first electrical conductivity (N-type), extending into the CSL 12 at a maximum depth lower than the depth of the CSL 12; a source region 17 in the body region 14; a first edge termination region 16, having the second electrical conductivity with a greater doping value than the doping value of the body region 14, which extends facing the front side 10a in electrical contact with the body region 14, extending into the CSL 12 at a maximum depth lower than the depth of the CSL 12; a second edge termination region 18, having the second electrical conductivity and doping value lower than the doping of the first edge termination region 16; a dielectric layer 20 on the front side 10a; a conductive layer 22 on the dielectric layer 20, forming an edge field plate of the electronic device 10; a first metallization 24a in electrical contact with the conductive layer 22 and a second metallization 24b in electrical contact with the first edge termination region 16 and with the source 17, in order to apply a predetermined bias voltage (typically in a voltage range 10-20 V) between the first and the second metallizations 24a, 24b.

The second edge termination region 18 extends into the semiconductor body 10 throughout a depth greater than the depth of the CSL 12.

The first and the second edge termination regions 16, 18 have the function of preventing or inhibiting the generation of an electric field of such a value as to damage the electronic device 1. In particular, the Applicant has verified that an edge termination region (here in particular the edge termination region 18) which extends to a greater depth than the CSL 12 locally interrupts the CSL 12 and allows the electric field to be reduced, distributing the field lines in the edge region, below the critical breakdown values of the semiconductor material and the field oxide used.

Since forming the CSL 12 provides for epitaxial growth or channeled deep ion implant, forming the second edge termination region 18 within the CSL 12 needs to provide a corresponding high-energy and high-dose ion implant to reach the desired depth while locally inverting the electrical conductivity (from N-type to P-type), and up to obtaining the desired doping value. It is clear that such a process step relating to the high-energy and high-dose ion implant may, in some situations, be undesired.

US2019/140095 relates to a semiconductor device, and more particularly, to a technique for relaxing electric field crowding in a voltage blocking area of a semiconductor device.

US2022/336590 relates to a silicon carbide (SiC) semiconductor device and a method for manufacturing the same.

However, the above-mentioned issues are not solved.

The need to overcome the drawbacks discussed above is therefore felt.

This aim is achieved by an electronic device and a manufacturing method thereof, as defined in the attached claims.

For a better understanding of the present invention, reference is made to the attached drawings wherein:
- Figure 1 illustrates, in lateral sectional view, an electronic device according to an embodiment which is not an object of the present invention, limitedly to an edge region of the electronic device;
- Figure 2 illustrates, in top view, a die including an active area and an edge region of an electronic device, according to one aspect of the present invention;
- Figure 3 illustrates, in lateral sectional view along scribe line III-III of Figure 2, the electronic device accommodated by the die of Figure 2, limitedly to the edge region;
- Figure 4 illustrates, by a flowchart, steps of a manufacturing method of the electronic device of Figure 3; and
- Figure 5 illustrates, in lateral sectional view, an electronic device, limitedly to the edge region, according to a further embodiment.

Preferred embodiments of the present invention are described hereinbelow, by way of non-limiting example.

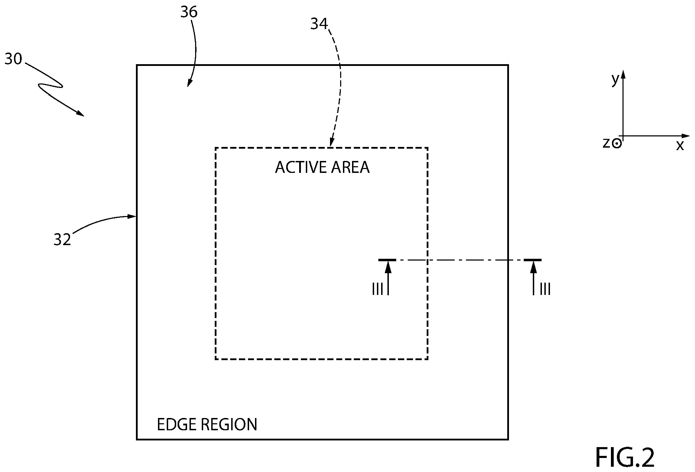

With reference to Figure 2, a die, or chip, 30, or part thereof, is illustrated in a triaxial reference system of orthogonal axes X, Y, Z. The die 30 is obtained after a step of dicing a semiconductor wafer, not illustrated. The die 30 is shown in top view on the plane XY.

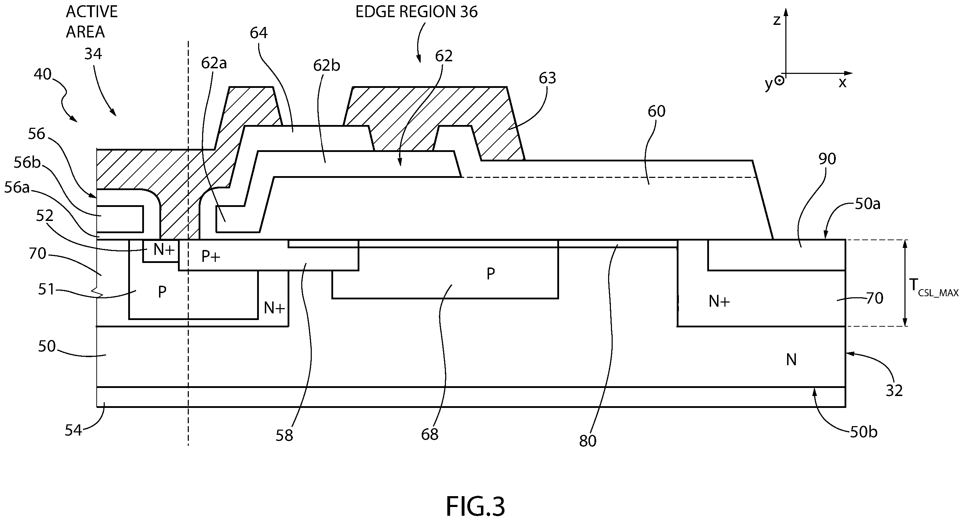

The die 30 comprises an outer edge 32 which physically delimits the die 30. The die 30 accommodates at least one electronic device 40, illustrated in part in Figure 3, such as for example a MOSFET, in particular a power MOSFET, even more in particular a vertical conduction MOSFET. In the following description, the wording "electronic device" and "MOSFET" are used interchangeably and without loss of generality.

The die 30 includes at least two functional regions: an active area 34, typically extending into a central portion of the die 30, and an edge region, or peripheral region, 36, which completely surrounds the active area 34. The edge region extends in practice between the active area 34 and the outer edge 32 and is externally delimited by the outer edge 32. The active area 34 includes the conductive channel region in use of the MOSFET 40. The edge region 36 is instead a region which does not have in use the conductive channel. The edge region 36 comprises functional elements for reducing or preventing the crowding of the electric field lines outside the active area, such as for example one or more edge termination regions, also called guard rings, as better described and illustrated with reference to Figure 3.

Figure 3 is a cross-sectional view on the plane XZ of a portion of the die 30 along scribe line III-III of Figure 2. The dashed line in Figure 3, which discriminates between the active area 34 and the edge region 36, is to be understood as qualitative.

The MOSFET 40 includes: a semiconductor body 50, in particular of silicon carbide (SiC), even more in particular of the 4H-SiC polytype. Alternatively, the semiconductor body 50 may be of 3C-SiC or 6H-SiC.

In general, the semiconductor body 50 is of a material having a crystalline structure or lattice configured so as to allow the ion implant by exploiting the channeling. Such a crystal lattice may be described through a periodic distribution of atom (or ion/molecule) groups. Ideally, considering a crystal which extends endlessly in spatial coordinates, the periodicity results in a translation invariance (or translation symmetry). The entire crystal is therefore generated by the periodic repetition of a fundamental unit, called unit cell, which may contain atom and/or ion and/or molecule groups. The translation symmetry implies that a generic point belonging to an elementary cell is in one-to-one correspondence with a point of the elementary cell obtained with a suitable translation from the first one.

The semiconductor body 50 has a first electrical conductivity (for example of N-type) and doping of the order of 1·10¹⁵-1·10²⁰ atoms/cm³. In one embodiment (not illustrated in the Figures), the semiconductor body 50 comprises a substrate having a drift layer formed (e.g., epitaxially grown) thereon. In this case, the substrate has a doping, for example, of the order of 1·10¹⁸-1·10²⁰ atoms/cm³ and the drift layer has a doping, for example, of the order of 1·10¹⁵-1·10¹⁷ atoms/cm³. The drift layer has, for example, a thickness comprised between 3 and 100 µm (boundaries included).

The semiconductor body 50 is delimited upwardly by a front side 50a and downwardly by a rear side 50b, opposite to each other along the direction of the axis Z. At the front side 50a a body region 51 is present, having a second electrical conductivity (of P-type) opposite to the first electrical conductivity. A source region 52 extends at the front side 50a into the body region 51. A drain region 54 extends at the rear side 50b. A gate region 56 extends, in a per se known manner, on the front side 50a and includes a gate dielectric 56a and a gate conductive region 56b on the gate dielectric 56a.

Figure 3 illustrates, for simplicity of representation, a single body region 51, a single source region 52 and a single gate region 56. However, it is evident that the MOSFET 40 may comprise any plurality of said body 51, source 52 and gate regions 56. In particular, the illustrated body 51, source 52 and gate regions 56 extend in proximity of the end of the active area 34.

The MOSFET 40 also comprises, within the semiconductor body 50, a first edge termination region 58, implanted at the front side 50a and facing the front side 50a. The first edge termination region 58 has the second electrical conductivity and doping (P+) greater than that of the body region 51. The first edge termination region 58 extends within the edge region 36 (and optionally in part also into the region of active area 34) in electrical contact with the body region 51. The first edge termination region 58 has, when biased to the body and source voltage, the function of shielding the structures of the device, which extend above the edge termination region 58 (in particular, the portion 62a of the conductive layer 62 described hereinbelow), from high electric fields.

A field dielectric layer ("field oxide") 60 extends above the first edge termination region 58 (on the front side 50a) and a conductive layer 62 (for example a metal layer or N-type doped polysilicon) extends on the dielectric layer 60. Layer 62 is configured to distribute the gate bias to the device (the gate conductive region 56b is in electrical connection with the layer 62).

The conductive layer 62 includes: a first portion 62a which extends over the first edge termination region 58 and is electrically insulated from the latter by a dielectric or oxide (e.g., SiO₂) layer; and a second portion 62b which extends above the dielectric layer 60. The first and the second portions 62a, 62b are in mutual structural and electrical continuity. The second portion 62b forms an edge field plate, of the MOSFET 40, as it takes the gate potential to the edge termination region 36.

The conductive layer 62 is (in a manner not illustrated in Figure) in electrical connection with the gate conductive region 56b and, in particular, it is formed during the same step of forming the gate conductive region 56b. A passivation layer 64 extends over the conductive layer 62, to protect and insulate the conductive layer 62. The passivation layer 64 is interrupted where the metallization 63 is in electrical contact with the conductive layer 62.

Optionally, the MOSFET 40 comprises a second edge termination region 68 having the second electrical conductivity (of P-type) and doping lower than the doping of the first edge termination region 58. The second edge termination region 68 extends at an end portion (or end region) of the first edge termination region 58, opposite the end portion (or end region) of the first edge termination region 58 which is in contact with the body region 51. The second edge termination region 68 therefore extends as an extension of the first edge termination region 58 within the edge region 36. The second edge termination region 68 has the function of distributing or thinning the field lines of the electric potential in such a way as to avoid a thickening of the field lines on the curvature radius of the first edge termination region 58, and thus maximizing the value of the edge breakdown voltage.

The doping density of the first edge termination region 58 is of the order of 1·10¹⁸-1·10²⁰ atoms/cm³. The doping density of the second edge termination region 68 is of the order of 1·10¹⁶-1·10¹⁸ atoms/cm³.

The thickness of the first edge termination region 58, along the direction Z starting from the front side 50a, is for example comprised between 0.3 and 1 µm (boundaries included). The thickness of the second edge termination region 68, along the direction Z starting from the front side 50a, is for example comprised between 0.5 and 2 µm (boundaries included).

The MOSFET 40 further comprises a Current Spreading Layer (CSL) 70, which extends into the semiconductor body 50 facing the front side 50a. The CSL 70 has a maximum thickness T_{CSL_MAX}, starting from the front side 50a, comprised between 0.3 and 2 µm along the axis Z (boundaries included). In general, the CSL 70 has a depth equal to that of the body 51, or extends below the body 51 by a value up to 1 µm. In one embodiment, the maximum depth reached by the CSL 70 is greater than the maximum depth reached by the body region 51. Thus, in this case, the body region 51 is completely contained in the CSL 70.

The CSL 70 forms an enrichment layer having the function of improving the value of on-state resistance Ron of the MOSFET 40. The doping of the CSL 70 is greater than the doping of the semiconductor body 50. The CSL 70 has, for example, doping of the order of 10¹⁷ atoms/cm³ or comprised between 2 and 20 times the doping of the portion of the semiconductor body 50 accommodating it.

According to one aspect of the present invention, the CSL 70 has a thickness, along the axis Z starting from the front side 50a, that is not uniform. In particular, the CSL 70 has the maximum thickness T_{CSL_MAX} at the active area 34 (where it performs its function of reducing Ron) and a different thickness T_{CSL_MIN} at a portion of the first edge termination region 58 (in particular, at least, at the end portion (or end region) of the first edge termination region 58 which is opposite to that in contact with the body region 51). In the embodiment wherein the MOSFET 40 has the second edge termination region 68, the CSL 70 has the thickness T_{CSL_MIN} also at the second edge termination region 68 (in particular at least throughout the entire extension of the second edge termination region 68). The value of T_{CSL_MIN} is lower than the value of T_{CSL_MAX}, in particular comprised between 0 and 0.3 µm. The value T_{CSL_MIN} is equal to zero where the P-dopant dose of the edge termination region 58 (and if any, region 68) is greater than the respective N-dopant dose of the CSL 70, due to the local inversion of the electrical conductivity type (from N to P).

The thickness T_{CSL_MAX} of the CSL 70 is greater than the maximum thickness of the first edge termination region 58 and also than the maximum thickness of the second edge termination region 68, when present.

According to one aspect of the present invention, the CSL 70 is formed by a channeled ion implant.

The channeled implant occurs when the ion beam during implant is aligned with the channeling directions. For example, in SiC, the direction 000-1 or the direction 11-23. Typically the substrates are cut from ingots grown in the 000-1 direction with a surface inclined (for dicing wafers) by 4° for substrates having a diameter of 150 mm or 200 mm. This entails that to implant with channeling on a 000-1 wafer it is necessary to tilt the ion beam during the implant with tilt of 4°, and for a 11-23 wafer of 13° or 21°.

The Applicant has verified that the channeling effect is altered by the presence of a masking surface layer arranged over the front side 50a of the semiconductor body 50, such as for example one or more natural or intentionally added oxide layers. In the case of using said masking surface layer, the thickness T_{CSL_MIN} of the CSL 70 may be equal to zero, or in the regions of the semiconductor body 50 at the masking surface layer the CSL 70 may be absent. The thickness value T_{CSL_MIN} of the CSL 70 is a function of the thickness of said masking surface layer and, for sufficiently high thicknesses of the masking surface layer, the CSL 70 does not extend below said masking surface layer.

The Applicant has also verified that the channeling effect is altered by an intentional damage to a region of the surface of the semiconductor body 50, at the front side 50a, i.e. whereat the channeled implant for forming the CSL 70 occurs. This damage may be obtained, for example, by ion implant of non-reactive or non-doping species, i.e. such as to cause damage to the crystal lattice of the semiconductor body 50, without locally altering the conductive characteristics thereof. Chemical species suitable for this purpose include for example ions of Si, Ar, Ge, He.

Therefore, according to one aspect of the present invention, a damaged region 80 is formed at the front side 50a, in order to alter or inhibit the channeling while forming the CSL 70.

The damaged region 80 extends to a maximum depth, in the semiconductor body 50 starting from the front side 50a, comprised for example between 0.1 and 0.6 µm (boundaries included). In one embodiment, the thickness of the damaged region 80 is uniform; in a further embodiment, the thickness of the damaged region 80 is not uniform but varies between a maximum value of 0.6 µm and a minimum value of 0.1 µm.

The damaged region 80 extends into the edge region 36 of the MOSFET 40, in particular at the portions of the semiconductor body 50 wherein it is desired to form the CSL 70 with the thickness T_{CSL_MIN}.

Forming the damaged region 80 comprises using implant doses greater than 10¹³ atoms/cm² and energies sufficient to cause the atoms to shift from the crystal structure throughout the necessary depth (e.g., energy in the range 30-300 keV, boundaries included). The implant that introduces the damage is not performed in channeling conditions and the annealing of the wafer during the process is avoided not to remove the damage produced.

According to a further embodiment, the damaged region 80 is formed by one or more steps of etching the front side 50a of the semiconductor body 50, for example a RIE (Reactive Ion Etching) process with physical etching characteristics (ion bombardment).

In order to damage by etching only the desired surface portion (i.e. the one whereat it is desired to have the CSL 70 with thickness T_{CSL_MIN}) an etching mask is used which exposes only the desired surface portion.

As a result of the two possible damaging steps mentioned above, the semiconductor body 50 does not have, at the damaged region 80, the same lattice structure as the semiconductor body 50 which extends laterally to the damaged region 80. In particular, the semiconductor body 50, where damaged, has an amorphous structure or a disordered crystalline structure or lattice structure with no spatial symmetry of the unintentionally damaged portions of the semiconductor body 50. The Applicant has verified that by carrying out an unmasked implant for forming the CSL 70, it is formed, however, at the damaged region 80, a thin implanted layer of thickness T_{CSL_MIN}. Since, as said, the region of CSL 70, having thickness T_{CSL_MIN}, has a thickness lower than the thickness of the first and the second edge termination regions 58, 68, the presence of the CSL 70 with thickness T_{CSL_MIN}, does not affect the operation of the MOSFET 40.

The value T_{CSL_MIN} is equal to zero where the P-dopant dose of the edge termination region 58 (and if any, region 68) is greater than the respective N-dopant dose of the CSL 70, due to the local inversion of the electrical conductivity type (from N to P). The thickness value of the CSL 70 is greater than zero, but smaller than T_{CSL_MAX}, at the damaged region 80 laterally to the first edge termination region 58 and to the second edge termination region 68 (when present).

Figure 3 further illustrates a channel stop region 90, optional, which extends laterally to the damaged region 80, at and facing the front side 50a. The channel stop region 90 extends in particular between the damaged region 80 and the edge 32 of the die 30. The channel stop region 90 is formed by implant of doping species having the first conductivity (N-type, for example obtained by doping with phosphorus) and dopant dose comprised between 1·10¹⁹ and 5·10²⁰ atoms/cm³. The channel stop region 90 has the function of forming an equipotential ring with the drain on the die edge.

It is also noted that, between the damaged region 80 and the edge 32 of the die 30 there is also present, optionally, a portion of CSL 70 having the depth value T_{CSL_MAX}, the channel stop region 90 extending within this portion of CSL 70 and having a respective depth value, in the semiconductor body 50, smaller than T_{CSL_MAX}.

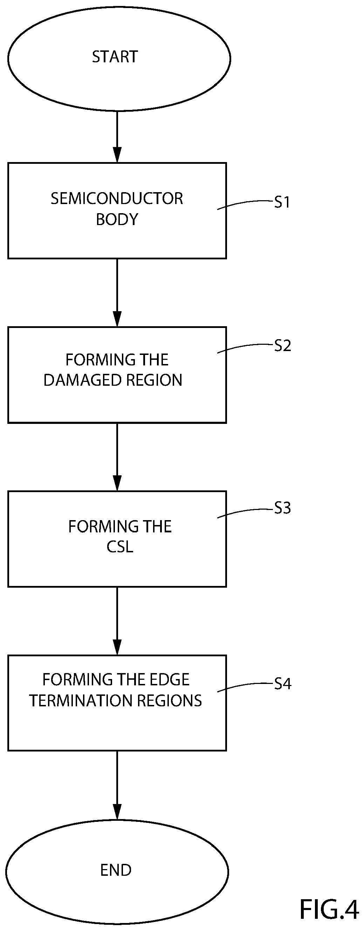

Figure 4 illustrates, by a flowchart, steps of a manufacturing process of the MOSFET 40, limitedly to the elements useful to understand the present invention.

With reference to Figure 4, step S1, the semiconductor body 50 is provided and, step S2, the damaged region 80 is formed according to any of the techniques described above. Then, step S3, the CSL 70 is formed by channeled ion implant. As previously described, the CSL 70 has different thicknesses T_{CSL_MIN} and T_{CSL_MAX} respectively at the damaged region 80 and laterally to the damaged region 80, as a result of the presence and the absence of the damaged region 80, even in the absence of an implant mask. Finally, step S4, the edge termination regions 58, 68 are formed by traditional or random ion implant (unchanneled).

Step S2 may be replaced by forming the masking surface layer, as previously described. However, forming the damaged region 80 through an implant has the advantage of not requiring, with respect to forming the masking surface layer, a further step of selectively removing the masking surface layer.

Following the steps S1-S4 described, the structure of the MOSFET 40 is completed, as regards the edge region 36, with the formation of the field dielectric layer 60, the conductive layer 62, the metallization 63 and the passivation layer 64.

The advantages of the present invention are evident from what has been previously described. In particular, according to the present invention, using a hard mask in step S3 in Figure 4 is not necessary. Furthermore, forming the edge termination regions 58, 68 does not require using a high-energy and high-dose ion implant to reach the desired depth and electrical conductivity.

Finally, it is clear that modifications and variations may be made to what is described and illustrated herein without thereby departing from the scope of the present invention, as defined in the attached claims.

For example, the present invention applies to an electronic device other than a vertical channel MOSFET, such as for example a horizontal channel MOSFET, a trenchFET, a diode, a triristor, a MESFET, a MISFET, an IGBT.

Furthermore, the semiconductor body 50 may be a material other than SiC, such as for example GaN.

Furthermore, the semiconductor body 50 may comprise a substrate of semiconductor material (SiC, GaN, etc.) and optionally one or more epitaxial surface layers grown on the substrate.

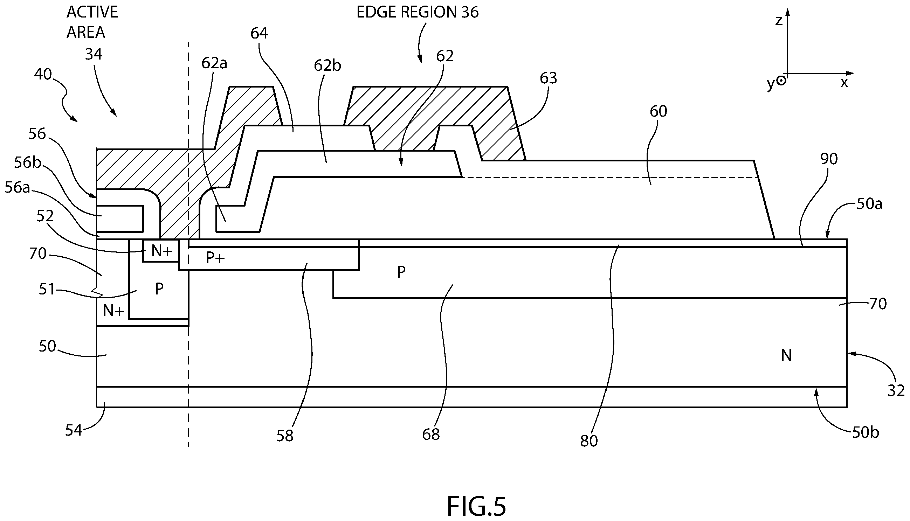

Furthermore, in one embodiment, the body region 51 shown in Figures 3 and 5, i.e. the body region in direct electrical connection with the first edge termination region 58, does not accommodate the source region 52. In fact, in this embodiment, the illustrated body region 51 extends up to the edge region 36, i.e. in proximity of an area of the device 40 designed not to participate in the electrical conduction; the absence of the source region prevents the flow of charge carriers (conduction current) towards the edge region 36.

In summary, therefore, the present invention relates to an electronic device 40, comprising:
- the semiconductor body 50, having a first electrical conductivity (e.g., N) and a first doping value, and provided with the front side 50a and the rear side 50b opposite to each other along the direction Z;
- the active area 34 configured to accommodate, in use, the conductive channel of the electronic device;
- the edge region 36, surrounding the active area 34 and in structural continuity with the active area 34, and accommodating at least in part the edge termination region (only the region 58 or both the regions 58 and 68, previously described) having a second electrical conductivity (e.g., P) opposite to the first electrical conductivity (N) and which extends into the semiconductor body 50 starting from the front side 50a up to a maximum depth, along the direction Z, having a first value (the first depth value is the value of the edge termination region 58 or the greater of the depth values of the edge termination region 58 and of the edge termination region 68 when the latter is present).

The edge region 36 also accommodates the current spreading layer, CSL, 70 extending into the active area 34 and in part into the edge region 36, facing the front side 50a, wherein the CSL 70 has the electrical conductivity N and a second doping value greater than the first doping value. The CSL 70 is at least absent at at least part of the edge termination region (i.e. at part of the region 58 and, if any, of the region 68). In other words, the CSL 70 has, at at least one part of the edge termination region (i.e. at part of the region 58 and, if any, of the region 68), the minimum depth value T_{CSL_MIN}, where the value T_{CSL_MIN} is equal to zero where the P-dopant dose of the edge termination region is greater than the respective N-dopant dose of the CSL 70. The CSL 70 also has depth, in the semiconductor body 50, starting from the front side 50a, variable between a maximum value T_{CSL_MAX} and the minimum value T_{CSL_MIN}, the maximum depth value T_{CSL_MAX} being greater than the first depth value and the minimum depth value T_{CSL_MIN} being smaller than the first depth value.

In a further embodiment, the electronic device 40 (here, a MOSFET) has, in the edge region 36, the damaged region 80 which extends throughout the entire extension of the edge region 36. Therefore, in the edge region 36, the CSL 70 never reaches the depth value T_{CSL_MAX}. The first edge termination region 58 and, if any, the second edge termination region 68 alternately extend throughout a portion of the damaged region 80 or throughout the entire extension of the damaged region 80.

With reference to Figure 5, in case both the damaged 80 and edge termination regions 58 (and optionally region 68) extend throughout the entire extension of the edge region 36, the CSL 70 is absent in the edge region 36. Elements of Figure 5 which correspond to elements of Figure 3 are illustrated with the same reference numerals and are not further described.

## Claims

1. An electronic device (40), comprising:
- a semiconductor body (50), having a first electrical conductivity (N) and a first doping value, and provided with a front side (50a);
- an active area (34) configured to accommodate, in use, a conductive channel of the electronic device;
- an edge region (36), surrounding the active area (34) and in structural continuity with the active area (34), and accommodating at least in part an edge termination region (58; 58, 68) having a second electrical conductivity (P) opposite to the first electrical conductivity (N) and which extends into the semiconductor body (50) starting from the front side (50a) up to a maximum depth having a first value along a direction (Z) orthogonal to the front side (50a);
- a current spreading layer, CSL, (70) extending in said active area (34) and in part in said edge region (36) facing the front side (50a), wherein the CSL (70) has the first electrical conductivity (N) and a second doping value greater than the first doping value,
**characterized in that** the CSL (70) has depth, in the edge region (36) starting from the front side (50a), variable between a second depth value (T_{CSL_MAX}) and a third depth value (T_{CSL_MIN}), said second depth value (T_{CSL_MAX}) being greater than the first depth value of the edge termination region, and said third depth value (T_{CSL_MIN}) being smaller than the first depth value of the edge termination region,
and wherein the CSL (70) has the third depth value (T_{CSL_MIN}) at at least one part of the edge termination region (58; 58, 68).

2. The electronic device (40) according to claim 1, wherein the semiconductor body (50) is of a material having a lattice structure with spatial symmetry,
the electronic device (40) further comprising a damaged region (80) extending for a part of the edge region (36) at the front side (50a) and wherein the damaged region (80)has an amorphous lattice structure or lattice structure with no spatial symmetry.

3. The electronic device (40) according to claim 2, wherein the edge termination region (58; 58, 68) extends at least in part at said damaged region (80), completely superimposed on said damaged region (80) where it is at said damaged region (80) thus forming a superimposition area, and also extends below the damaged region (80) up to said first depth value of the edge termination region (58; 58, 68).

4. The electronic device (40) according to claim 3, wherein the third depth value (T_{CSL_MIN}) is zero,
wherein the CSL (70) has the third depth value (T_{CSL_MIN}) at the superimposition zone between the edge termination region (58; 58, 68) and the damaged region (80),
and wherein the damaged region (80) further extends laterally to the superimposition zone,
the CSL (70) having a fourth depth value, greater than zero and smaller than the second depth value (T_{CSL_MAX}), at the damaged region (80) laterally and adjacent to the superimposition zone.

5. The electronic device (40) according to any of claims 2-4, wherein said damaged region (80) accommodates non-reactive or non-doping ion species, such as for example Si, Ar, Ge, He.

6. The electronic device (40) according to any of claims 2-5, wherein said damaged region (80) extends into the semiconductor body (50), starting from the front side (50a), throughout a maximum depth having a fifth value which is smaller than the first and the second depth values (T_{CSL_MAX}).

7. The electronic device (40) according to claim 6, wherein the fifth depth value of the damaged region (80) is comprised between 0.1 and 0.6 µm.

8. The electronic device (40) according to any of the preceding claims, wherein the active area (34) comprises at least one body region (51) having the second electrical conductivity (P), and at least one source region (52) having the first electrical conductivity (N) in the body region,
wherein the body region extends into the semiconductor body (50), starting from the front side (50a), up to a maximum depth having a sixth value which is smaller than the second depth value (T_{CSL_MAX}).

9. The electronic device (40) according to claim 8, wherein the edge termination region (58; 58, 68) is in electrical contact with the body region and has a greater doping than the respective doping of the body region.

10. The electronic device (40) according to any of the preceding claims, wherein the edge termination region (58; 58, 68) comprises a first guard ring (58) and a second guard ring (68) in mutual electrical continuity,
the first guard ring having a greater doping than the doping of the second guard ring and being in direct electrical connection to the body region through a first end portion, the second guard ring being in direct electrical connection to the first guard ring at a second end portion of the first guard ring.

11. The electronic device (40) according to any of the preceding claims, wherein the semiconductor body (50) is of Silicon Carbide, in particular of 3C-SiC, 4H-SiC, 6H-SiC.

12. The electronic device (40) according to any of the preceding claims, wherein said device is one of:
a vertical conduction transistor further comprising a drain region (54) extending at a rear side (50b), opposite to the front side (50a) along said direction (Z), of the semiconductor body (50);
a horizontal conduction transistor further comprising a drain region extending at the front side (50a) of the semiconductor body (50).

13. An electronic device (40), comprising:
- a semiconductor body (50), having a first electrical conductivity (N) and a first doping value, and provided with a front side (50a);
- an active area (34) configured to accommodate, in use, a conductive channel of the electronic device;
- an edge region (36), surrounding the active area (34) and in structural continuity with the active area (34), and accommodating at least in part an edge termination region (58; 58, 68) having a second electrical conductivity (P) opposite to the first electrical conductivity (N) and which extends into the semiconductor body (50) starting from the front side (50a) up to a maximum depth having a first value along a direction (Z) orthogonal to the front side (50a);
- a current spreading layer, CSL, (70), extending into said active area (34) and having the first electrical conductivity (N) and a second doping value greater than the first doping value,
**characterized in that** the CSL (70) is absent at the edge region (36).

14. A method of manufacturing an electronic device (40), comprising the steps of:
- arranging (S1) a semiconductor body (50), having a first electrical conductivity (N) and a first doping value, and provided with a front side (50a), the semiconductor body (50) comprising an active area (34) configured to accommodate, in use, a conductive channel of the electronic device and an edge region (36), surrounding the active area (34) and in structural continuity with the active area (34);
- forming, at least in part in the edge region (36), an edge termination region (58; 58, 68) having a second electrical conductivity (P) opposite to the first electrical conductivity (N) and which extends into the semiconductor body (50) starting from the front side (50a) up to a maximum depth having a first value along a direction (Z) orthogonal to the front side (50a);
- forming (S3) a current spreading layer, CSL, (70) in said active area (34) and in part in said edge region (36), facing the front side (50a), wherein the CSL (70) has the first electrical conductivity (N) and a second doping value greater than the first doping value,
**characterized in that** the step of forming (S3) the CSL (70) comprises forming the CSL (70) with a depth, in the edge region (36) starting from the front side (50a), variable between a second depth value (T_{CSL_MAX}) and a third depth value (T_{CSL_MIN}), said second depth value (T_{CSL_MAX}) being greater than the first depth value and said third depth value (T_{CSL_MIN}) being smaller than the first depth value,
and wherein the CSL (70) has the third depth value (T_{CSL_MIN}) at at least one part of the edge termination region (58; 58, 68).

15. The method according to claim 14, wherein the semiconductor body (50) is of a material having a lattice structure with spatial symmetry, further comprising the step of altering, in a selective portion of the edge region (36) at the front side (50a), said spatial symmetry thus forming a damaged region (80) with an amorphous lattice structure or lattice structure with no spatial symmetry,
said step of forming the damaged region (80) being performed before the steps of forming the CSL (70) and the edge termination region (58; 58, 68).

16. The method according to claim 15 wherein the step of forming the damaged region (80) comprises performing an implant of non-reactive or non-doping ion species, such as for example Si, Ar, Ge, He.

17. The method according to claim 15 wherein the step of forming the damaged region (80) comprises performing an etching.

18. The method according to any of claims 15-17 wherein the step of forming the CSL (70) is performed before the step of forming the edge termination region (58; 58, 68), and comprises performing a channeled ion implant in the semiconductor body (50), at both the damaged region (80) and laterally to the damaged region (80),
the CSL (70) having the second depth value (T_{CSL_MAX}) laterally to the damaged region (80) and the third depth value (T_{CSL_MIN}) at the damaged region (80) .

19. The method according to any of claims 15-18 wherein forming the edge termination region (58; 58, 68) comprises performing an implant of ion species having the second electrical conductivity (P) at least in part at said damaged region (80).

20. The method according to claim 15 or 16 wherein the step of forming the damaged region (80) comprises performing said implant of non-reactive or non-doping ion species using the following parameters: implant energy comprised between 30 keV and 300 keV; implant dose of the order of 10¹³ atoms/cm².
